(19) **Europäisches Patentamt**
**European Patent Office**
**Office européen des brevets**

(11) **EP 3 021 365 B1**

(12) **FASCICULE DE BREVET EUROPEEN**

(45) Date de publication et mention
de la délivrance du brevet:
**09.01.2019 Bulletin 2019/02**

(51) Int Cl.:
*H01L 31/068* (2012.01)      *H01L 31/18* (2006.01)

(21) Numéro de dépôt: **15194533.4**

(22) Date de dépôt: **13.11.2015**

(54) **PROCÉDÉ DE RESTAURATION DE CELLULES SOLAIRES PHOTOVOLTAÏQUES À BASE DE SILICIUM**

VERFAHREN ZUR RESTAURIERUNG VON FOTOVOLTAIK-SOLARZELLEN AUF SILIZIUMBASIS

METHOD FOR RESTORING SILICON-BASED PHOTOVOLTAIC SOLAR CELLS

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.11.2014 FR 1461000**

(43) Date de publication de la demande:
**18.05.2016 Bulletin 2016/20**

(73) Titulaire: **Commissariat à l'Energie Atomique et
aux Energies
Alternatives
75015 Paris (FR)**

(72) Inventeurs:
• **Cascant-Lopez, Miguel
46183 L'Eliana (ES)**
• **Dubois, Sébastien
74950 Scionzier (FR)**

(74) Mandataire: **Talbot, Alexandre
Cabinet Hecké
28 Cours Jean Jaurès
38000 Grenoble (FR)**

(56) Documents cités:
**EP-A1- 1 732 142       US-A- 4 532 199
US-A1- 2014 008 234    US-A1- 2014 124 030**

• **Jan Schmidt ET AL: "Presented at the 16 th
European Photovoltaic PROGRESS IN
UNDERSTANDING AND REDUCING THE LIGHT
DEGRADATION OF CZ SILICON SOLAR CELLS",
16th European Solar Energy Conference, 1 mai
2000 (2000-05-01), XP055198673, Extrait de
l'Internet:
URL:https://digitalcollections.anu.edu.au/
bitstream/1885/40853/5/jancz.pdf [extrait le
2015-06-26]**
• **Craig C Young ET AL: "AN
ELECTRON-CYCLOTRON-RESONANCE
PLASMA APPARATUS FOR HYDROGENATED
AMORPHOUS-SILICON THIN FILM PRODUCTION
A THESIS IN ELECTRICAL ENGINEERING
Submitted to the Graduate Faculty of Texas Tech
University in Partial Fulfillment of the
Requirements for the Degree of MASTER OF
SCIENCE IN ELECTRICAL ENGINEER", , 1
décembre 1990 (1990-12-01), XP055254480,
Extrait de l'Internet:
URL:https://ttu-ir.tdl.org/ttu-ir/bitstrea
m/handle/2346/17281/31295005978241.pdf?seq
uence=1 [extrait le 2016-03-02]**

**Description**

**Domaine technique de l'invention**

L'invention est relative à un procédé et un dispositif destinés à réduire les effets de dégradation du rendement sous éclairement des cellules solaires photovoltaïques à base de silicium.

**État de la technique**

Les cellules solaires photovoltaïques réalisées à partir de substrats en silicium, rencontrent généralement un problème créé par un phénomène de dégradation du rendement photovoltaïque sous éclairement. Ce phénomène survient lors des premières heures d'éclairement des cellules solaires photovoltaïques, et il est usuellement appelé, effet « LID » (LID pour l'abréviation anglaise de « Light-Induced-Degradation »).

Les mécanismes physiques à l'origine de cette dégradation du rendement des cellules solaires photovoltaïques sous éclairement, restent néanmoins mal connus. Par ailleurs, quelques études scientifiques ont montré que des éléments légers présents dans le silicium, notamment les atomes d'hydrogène (H), de bore (B) et d'oxygène (O) participent généralement à la l'activation de défauts lors de l'éclairement des cellules solaires photovoltaïques.

Les effets « LID » peuvent être atténués en injectant des porteurs de charges dans les cellules solaires photovoltaïques tout en chauffant lesdites cellules.

La demande internationale WO 2007/107351 divulgue un procédé visant une stabilisation du rendement des cellules solaires photovoltaïques lors de l'éclairement. Dans ce document, le procédé de restauration des cellules comporte une étape d'injection de porteurs de charge via un éclairement ou une polarisation de la cellule solaire photovoltaïque, et une étape de chauffage du substrat à une température comprise entre 50 °C et 230 °C.

Ce procédé de restauration a permis à la cellule solaire photovoltaïque traitée, de retrouver des performances stables sous des conditions normales de fonctionnement.

Cependant, le procédé décrit dans le document cité ci-dessus, nécessite des temps de traitement élevés pour une restauration complète des cellules photovoltaïques. Par temps de traitement, on entend la durée au cours de laquelle les cellules solaires sont maintenues à une certaine température lors de la génération de porteurs de charge dans les cellules. Les temps de traitement peuvent atteindre une centaine de minutes, ce qui rend ce procédé incompatible avec les procédés industriels usuels de fabrication des cellules solaires photovoltaïques.

Par ailleurs, la cinétique de restauration des cellules photovoltaïques peut être accélérée en augmentant la quantité de porteurs de charge présents dans la cellule solaire photovoltaïque traitée. Cette augmentation peut être réalisée notamment en augmentant, la puissance de l'éclairement incident ou l'intensité du courant électrique injecté dans la cellule. Cependant, augmenter la puissance lumineuse incidente ou le courant électrique injecté, peut entraîner une élévation très importante de la température de la cellule solaire photovoltaïque, limitant ou supprimant les effets de restauration de la cellule solaire photovoltaïque.

**Objet de l'invention**

Il existe un besoin de prévoir un procédé efficace, rapide, et facile à réaliser pour restaurer les cellules solaires photovoltaïques à base de silicium contre la dégradation du rendement photovoltaïque lors de l'éclairement, tout en préservant l'intégrité mécanique et les performances photovoltaïques des cellules traitées.

On tend à satisfaire ce besoin et à pallier les inconvénients cités ci-dessus en prévoyant un procédé de traitement d'un élément photovoltaïque contre la dégradation du rendement sous éclairement, comportant au moins les étapes suivantes :

- prévoir ledit élément comportant un substrat à base de silicium, muni en surface d'au moins une région émettrice;
- générer des porteurs de charge dans le substrat, tout en maintenant le substrat à une température comprise dans un intervalle de température compris entre 20°C et 230 °C et de préférence entre 50°C et 230°C;
- soumettre le substrat à un champ magnétique pendant l'étape de génération des porteurs de charge, le champ magnétique ayant une composante sensiblement parallèle à l'interface entre la région émettrice et le substrat, ladite composante ayant une intensité comprise entre $10^{-4}$ T et $5.10^{-1}$ T et avantageusement supérieure à $10^{-3}$ T.

Avantageusement, l'étape de génération des porteurs de charge est obtenue par éclairement du substrat. D'une manière préférentielle, l'éclairement est obtenu en utilisant une lumière ayant une longueur d'onde supérieure ou égale à 500nm, et de préférence supérieure ou égale 800nm, et inférieure ou égale à 1300nm, et de préférence inférieure ou égale à 1000nm.

Par ailleurs, selon un mode de réalisation avantageux :

- le substrat est en silicium dopé bore avec une concentration comprise entre $4,0 \times 10^{14}$ at/cm$^{-3}$ et $7,0 \times 10^{16}$ at/cm$^{-3}$ ; et
- le temps de traitement t de l'élément photovoltaïque, en secondes, est supérieure ou égale à :

$$C_1 * \left( \left( C_2 + \frac{1 - C_2}{1 + \left( \dfrac{B_c}{0,0169} \right)^{1,7352}} \right) * I \right)^{C_3} * e^{C_4 / T}$$

où :

- T correspond à la température en kelvin du substrat ;
- $B_c$ correspond à l'intensité en Tesla de ladite composante du champ magnétique ;
- I correspond à l'irradiance en sun du rayonnement projeté sur la surface du substrat ;
- $C_1$ correspond à une première constante comprise entre $1,3 \times 10^{-5}$ et $3,2 \times 10^{-5}$ et préférentiellement égale à $1,7 \times 10^{-5}$ ;
- $C_2$ correspond à une deuxième constante comprise entre 1,00 et 32,0 et préférentiellement égale à 4,32 ;
- $C_3$ correspond à une troisième constante comprise entre -1,00 et -2,00 et préférentiellement égale à -1,62 ;
- $C_4$ correspond à une quatrième constante comprise entre 6562 et 8523 et préférentiellement égale à 7500.

En outre, si le substrat est en silicium dopé bore avec une concentration strictement supérieure à $7 \times 10^{16}$ at/cm$^{-3}$, le temps de traitement t de l'élément photovoltaïque, en secondes, est avantageusement supérieure ou égale à :

$$\left( \frac{C_1'}{\left( C_2' + \dfrac{1 - C_2'}{1 + \left( \dfrac{B_c}{0,0169} \right)^{1,7352}} \right) * I} + C_3' \right) * e^{C_4' / T}$$

où :

- T correspond à la température en kelvin du substrat ;
- $B_c$ correspond à l'intensité en tesla de ladite composante du champ magnétique ;
- I correspond à l'irradiance en sun du rayonnement projeté sur la surface du substrat ;
- $C_1'$ correspond à une première constante additionnelle comprise entre $1,2 \times 10^{-8}$ et $1,9 \times 10^{-8}$ et préférentiellement égale à $1,51 \times 10^{-8}$ ;
- $C_2'$ correspond à une deuxième constante additionnelle comprise entre 1,00 to 32,0 et préférentiellement égale à 4,32 ;
- $C_3'$ correspond à une troisième constante additionnelle comprise entre $2,5 \times 10^{-8}$ et $4,0 \times 10^{-8}$ et préférentiellement égale à $4,0 \times 10^{-8}$ ; et
- $C_4'$ correspond à une quatrième constante additionnelle comprise entre 6562 et 8523 et préférentiellement égale à 7500.

Selon un mode de réalisation, le procédé de traitement comporte une étape de formation de contacts électriques sur le substrat, et l'étape de génération des porteurs de charge comporte une application d'une tension électrique externe aux contacts électriques.

Par ailleurs, pour pallier les inconvénients cités ci-dessus on prévoit également un dispositif de traitement d'un élément photovoltaïque contre la dégradation du rendement sous éclairement, l'élément photovoltaïque comprenant un substrat en silicium muni d'au moins une région émettrice, le dispositif comportant :

- des moyens de génération de porteurs de charge dans le substrat ;
- des moyens de traitement thermique configurés pour maintenir le substrat à une température comprise dans l'intervalle de température entre 20 °C et 230 °C et de préférence entre 50°C et 230°C ; et
- des moyens d'application d'un champ magnétique balayant un entrefer configuré pour comporter l'élément photovoltaïque, lesdits moyens d'application étant configurés pour que le champ magnétique ait une composante sensiblement parallèle à l'interface entre la région émettrice et le substrat, et pour que la composante du champ magnétique ait une intensité comprise entre $10^{-4}$ T et $5.10^{-1}$ T et avantageusement supérieure à $10^{-3}$ T.

Selon un autre mode de réalisation, les moyens d'application d'un champ magnétique comportent des aimants permanents, et/ou un électroaimant.

D'une manière préférentielle, les moyens de génération de porteurs de charge dans l'élément photovoltaïque comportent une source lumineuse destinée à éclairer l'élément photovoltaïque.

Avantageusement, le substrat est muni de contacts électriques et les moyens de génération de porteurs de charge dans le substrat comportent des moyens d'application d'une tension électrique externe aux contacts électriques.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 représente, de manière schématique, en vue de coupe, un mode de réalisation d'un dispositif de restauration d'éléments photovoltaïques ;
- la figure 2 représente, de manière schématique, en vue de coupe, un exemple d'un élément photovoltaïque en présence d'un champ magnétique ;
- la figure 3 représente, le tracé de la distribution en profondeur de la concentration des porteurs de charge minoritaires dans le substrat d'un élément photovoltaïque pour plusieurs valeurs de mobilités des électrons et des trous ;
- la figure 4 représente, le tracé de la variation de la concentration moyenne des porteurs de charge minoritaires au sein du substrat d'un élément photovoltaïque, en fonction de l'intensité du champ magnétique, selon un mode de réalisation ;
- les figures 5a et 5b représentent des tracés de la distribution en profondeur de la concentration des porteurs de charge minoritaires dans le substrat d'un élément photovoltaïque, éclairé respectivement par deux types de rayonnement et pour différentes valeurs de l'intensité du champ magnétique appliqué au substrat ;
- la figure 6 représente, le tracé du gain du temps de régénération de l'élément photovoltaïque en fonction de l'intensité du champ magnétique, selon un mode de réalisation.

## Description de modes de réalisation préférentiels de l'invention

Un procédé de traitement, ou de restauration, d'un élément photovoltaïque notamment une cellule solaire photovoltaïque, est décrit ci-après.

Avantageusement, le procédé traite l'élément photovoltaïque contre la dégradation du rendement sous éclairement, par génération de porteurs de charge dans ledit élément. Le procédé tire profit de l'effet d'un champ magnétique transverse pour améliorer la cinétique et l'efficacité de restauration des éléments traités.

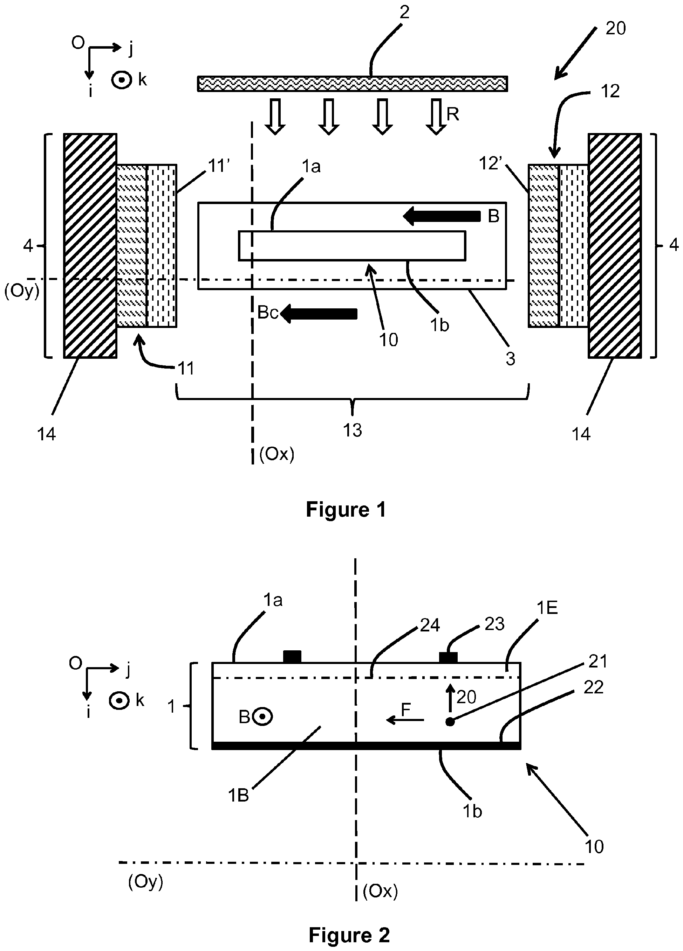

Selon un mode de réalisation illustré aux figures 1 et 2, le procédé prévoit un élément photovoltaïque 10 comportant un substrat 1 à base de silicium. Le substrat 1 est muni d'une face avant 1a et d'une face arrière 1b opposées, et de préférence sensiblement parallèles, et il peut être à base de silicium amorphe, monocristallin ou multicristallin. Le substrat 1 est muni en surface, au niveau de la face 1a, d'au moins une région émettrice 1E. Une interface 24 sépare la région émettrice 1E d'une région de base 1B. Généralement, l'épaisseur de la région de base 1B est largement supérieure à l'épaisseur de la région émettrice 1E. Ainsi, par la suite on parlera de l'interface 24 entre la région émettrice 1E et le substrat 1.

La face avant 1a est destinée à recevoir une intensité lumineuse, pour générer préférentiellement un photocourant résultant. Le photocourant généré est généralement proportionnel à l'intensité lumineuse reçue en face avant 1a par le substrat 1.

L'élément photovoltaïque 10 est préférentiellement une cellule solaire de type Al-BSF. L'élément photovoltaïque 10 peut être également une cellule photovoltaïque de type PERC ou PERT (PERC pour l'abréviation anglaise de « Passivated Emitter and Rear Cell » et PERT pour l'abréviation anglaise de « Passivated Emitter, Rear Totally diffused cell »). Une cellule solaire de type Al-BSF comporte une passivation par effet de champ à l'aide d'un fort dopage au niveau de la face arrière de la cellule. La barrière de potentiel induite par la différence de niveau de dopage entre la base et la face arrière tend à confiner les porteurs minoritaires dans la base et à les éloigner du bord de la cellule. Ce dopage est généralement réalisé grâce au contact en face arrière à base d'aluminium qui vient former un alliage avec le silicium lors du recuit. Dans ces conditions, une zone dopée P+ est formée sur l'ensemble de la face arrière de la cellule : on parle alors de champ de surface arrière ou BSF (BSF pour l'abréviation anglaise de « Back Surface Field »).

Ainsi, la face arrière 1b du substrat 1 peut être recouverte par une couche en aluminium formant une prise de contact pour ledit élément photovoltaïque 10. La prise de contact en face avant est avantageusement formée par un contact ohmique à base d'aluminium. En fait, l'aluminium et l'argent possèdent une perméabilité magnétique proche de 1, permettant de manière avantageuse, d'atténuer la distorsion des lignes de champ magnétique au sein du substrat 1. Par ailleurs, le silicium qui constitue le matériau de base de l'élément photovoltaïque 10 a également une perméabilité magnétique proche de 1.

Le procédé de restauration comporte une étape de génération de porteurs de charge dans le substrat 1 en le chauffant. Le chauffage du substrat est réalisé en maintenant le substrat 1 à une température comprise entre 20 °C et 230 °C.

Préférentiellement, le procédé de restauration comporte une étape d'éclairement de l'élément photovoltaïque 10 configurée pour générer des porteurs de charge dans le substrat 1. Autrement dit, l'étape de génération des porteurs de charge est obtenue par éclairement du substrat 1.

Selon le mode particulier illustré à la figure 1, la génération de porteurs de charge est réalisée par des moyens comportant préférentiellement une source lumineuse 2 éclairant l'élément photovoltaïque 10. Ce dernier, peut être éclairé par différents types de sources lumineuses. Par ailleurs, les moyens de génération de porteurs de charge peuvent également constituer une source de chaleur configurée à la fois pour éclairer le substrat 1 et pour le chauffer.

Avantageusement, l'élément photovoltaïque 10 reçoit un éclairement supérieur à 4000 W/m$^2$ pendant le procédé de restauration.

La génération de porteurs de charge peut être réalisée par éclairement et/ou par injection d'un courant électrique dans le substrat 1, notamment par une source de différence de potentiel externe par rapport au substrat 1.

Comme illustré à la figure 2, le substrat 1 comporte préférentiellement au niveau de la face avant 1a des contacts électriques. En fait, le procédé comporte avantageusement une formation de contacts électriques 23 sur le substrat 1. L'étape de génération des porteurs de charge est obtenue par application d'une tension électrique externe aux contacts 23.

Ainsi, les moyens de génération de porteurs de charge dans le substrat 1, comportent en outre des moyens d'injection (non représentés aux figures) d'un courant électrique dans l'élément photovoltaïque 10. Préférentiellement, une densité de courant supérieure à 30 mA/cm$^2$ est injectée dans l'élément 10 à traiter.

Pour réaliser l'étape de chauffage, le substrat 1 est maintenu à une valeur de température comprise dans l'intervalle de température 20 °C - 230 °C, et de préférence entre 50 °C et 230 °C. La température peut être fixe ou varier dans la gamme décrite, durant la génération des porteurs de charge. Les étapes de chauffage de la cellule solaire 1 et d'injection des porteurs de charge dans le substrat 1 sont des étapes réalisées simultanément, afin de permettre à l'élément photovoltaïque 10 traité, de retrouver des performances stables sous des conditions normales de fonctionnement.

De manière avantageuse, la température de l'élément photovoltaïque 10 est maintenue à une valeur ou une plage de température cible, comprise dans l'intervalle de température 120 °C - 210 °C. Le chauffage de l'élément photovoltaïque 10 peut être réalisé par une source externe de chaleur ou par les moyens de génération 2 de porteurs de charge, par exemple par des lampes halogènes.

En outre, le procédé de traitement prévoit des moyens d'application 4 d'un champ magnétique B au substrat. Autrement dit, le procédé de traitement comporte une étape d'application d'un champ magnétique B traversant l'élément photovoltaïque 10. Comme illustré à la figure 1, le substrat 1 est soumis à un champ magnétique B ayant une composante Bc sensiblement parallèle à l'interface 24 entre la région émettrice 1E et le substrat 1. L'interface 24 représente l'interface entre les deux types opposés de dopage présents dans le substrat 1, autrement dit l'interface de la jonction p/n, formant la région de base 1B et la région émettrice 1E.

Généralement, l'interface 24 est parallèle à la face avant 1a et la face arrière 1b. Selon un mode de réalisation particulier, le substrat 1 est soumis à un champ magnétique B ayant une composante Bc sensiblement perpendiculaire à un axe (Ox) traversant la face avant 1a et la face arrière 1b.

Par composante du champ magnétique B, on entend une composante selon un repère orthonormé (O, i, j, k). Préférentiellement, les faces 1a et 1b sont sensiblement parallèles, et l'axe (Ox) est sensiblement perpendiculaire aux faces 1a et 1b.

L'élément photovoltaïque 10, autrement dit le substrat 1 comporte au niveau de la face 1b, un contact arrière 22 préférentiellement à base d'aluminium, générant un champ de surface arrière BSF. Le substrat 1 comporte également au niveau de la face avant 1a les contacts électriques 23. Ainsi, le mouvement des porteurs de charge 21 suit une direction moyenne 20 sensiblement perpendiculaire à l'interface 24, notamment aux faces 1a et 1b.

Le champ magnétique B appliqué au substrat 1 est configuré, de sorte à ne pas être parallèle à la direction moyenne 20 du mouvement général des porteurs de charge 21. Sinon, la force de Lorentz F engendrée serait alors nulle, et le champ magnétique B n'aurait pas d'influence notable sur la concentration des porteurs de charge minoritaires 21 dans le substrat 1.

Des simulations numériques par le logiciel PC1D développé par l'université « New South Wales » ont été réalisées pour étudier l'influence d'un champ magnétique sur la concentration des porteurs de charge minoritaires dans un élément photovoltaïque.

Les simulations ont concerné des cellules solaires de type Al-BSF. La cellule Al-BSF étudiée comporte un substrat 1 en silicium de 200 $\mu$m d'épaisseur dopé p, et une concentration en charges libres majoritaires a l'équilibre de $6\times10^{15}$ at/cm$^3$. Les simulations numériques ont été réalisées en considérant la cellule solaire en circuit ouvert, et un éclairement en face avant par un rayonnement ayant un spectre de AM1.*5G*, autrement dit, ayant une irradiance de 1000 W/m$^2$. En outre, les simulations numériques ont été réalisées en considérant que la durée de vie des porteurs minoritaires dans le substrat 1 de l'élément photovoltaïque 10 est égale à $10^{-3}$ s.

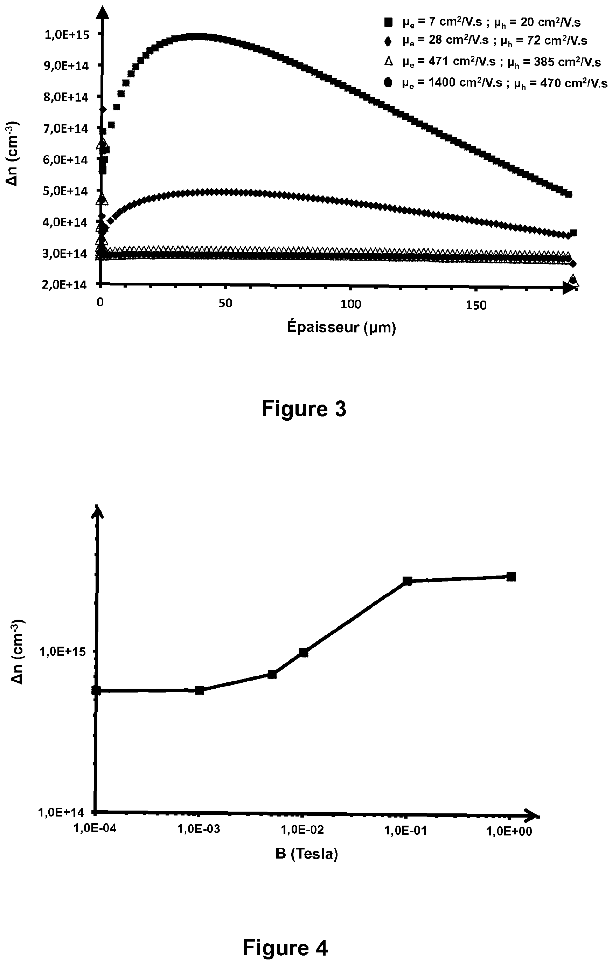

La figure 3 représente la distribution des porteurs de charges minoritaires en fonction de la profondeur du substrat 1, obtenue par les simulations numériques pour différentes valeurs de mobilité des électrons ($\mu_e$) et des trous ($\mu_h$) dans le substrat 1, lorsque l'on applique différentes valeurs de champ magnétique. Les résultats des simulations numériques tracés à la figure 3, indiquent clairement que la concentration des porteurs minoritaires augmente lorsque la mobilité des porteurs diminue. En outre, cette augmentation est obtenue sous des conditions d'éclairement favorables au phénomène de dégradation du rendement sous éclairement.

Les résultats des simulations montrent que l'application d'un champ magnétique transverse dans le substrat 1 entraîne une augmentation de la concentration des porteurs minoritaires.

Selon le mode de réalisation avantageux des figures 1 et 2, le champ magnétique B est parallèle à l'interface 24 entre la région émettrice 1E et le substrat 1, ou la région de base 1B. Préférentiellement, le champ B est configuré de sorte à être perpendiculaire à l'axe (Ox). Autrement dit, la direction du champ magnétique B est dans le plan (O, j, k). De ce fait, une force parallèle à l'interface 24 (*i.e.* aux faces 1a et 1b du substrat 1) est appliquée aux porteurs de charge 21 en mouvement. L'amplitude de cette force générée est alors maximisée, entrainant une forte diminution de la mobilité des porteurs de charge. Pour une intensité fixée du champ magnétique B, une telle orientation du champ magnétique génère avantageusement une augmentation optimale de la quantité des porteurs de charge minoritaires au sein du substrat 1, permettant ainsi une amélioration de la cinétique du procédé de restauration.

La figure 4 illustre l'évolution de la concentration moyenne des porteurs de charge minoritaires $\Delta n$ en fonction de l'intensité du champ magnétique appliqué au substrat 1. La cellule étudiée est la même que celle décrite ci-dessus et dont les résultats des simulations sont tracés à la figure 3. En outre, les calculs ont été effectués en considérant que le procédé de restauration a été réalisé à une température de 127 °C, et que le champ magnétique B était perpendiculaire à l'axe (Ox). Les simulations numériques ont été réalisées en considérant un éclairement en face avant par un rayonnement ayant un spectre de AM1.5G, autrement dit, ayant une irradiance de 1000 W/m$^2$.

Selon un mode de réalisation préférentiel, l'éclairement est obtenu en utilisant une lumière ayant une longueur d'onde supérieure ou égale à 500 nm, et de préférence supérieure ou égale à 800 nm, et inférieure ou égale à 1300 nm, et de préférence inférieure ou égale à 1000 nm.

La figure 4 montre que la concentration moyenne $\Delta n$ augmente avec l'augmentation de l'intensité du champ magnétique B appliqué au substrat 1 dans le procédé de traitement. Cette augmentation est d'autant plus marquante que l'intensité du champ magnétique B est supérieure à 0,001 T. Avantageusement, le procédé de traitement est réalisé en utilisant un champ magnétique B dont la composante Bc a une intensité comprise entre $10^{-4}$ T et $5\times10^{-1}$ T et avantageusement supérieure ou égale à 0,001 T.

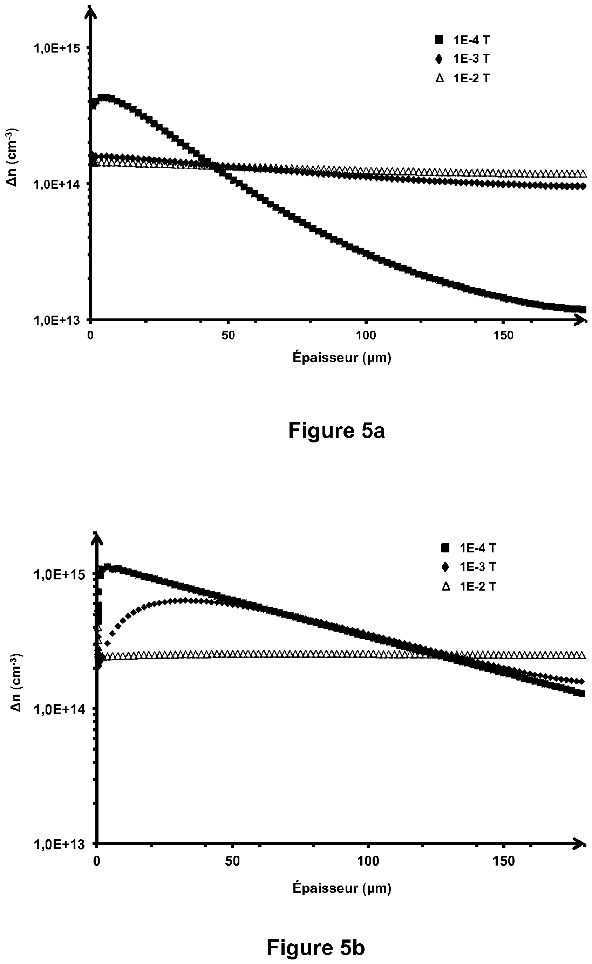

Selon un mode de réalisation avantageux, l'étape d'éclairement de l'élément photovoltaïque 10 est réalisée par un rayonnement monochromatique infrarouge (R). Préférentiellement, le rayonnement (R) a une longueur d'onde d'environ 1000 nm. Les figures 5a et 5b illustrent la distribution en profondeur (l'origine étant la face avant 1a) de la concentration moyenne des porteurs de charge minoritaires $\Delta n$. Chacune des figures 5a et 5b représente trois distributions correspondant à trois intensités du champ magnétique B perpendiculaire à l'axe (Ox) égales à $10^{-4}$, $10^{-3}$ et $10^{-2}$ T.

Les calculs ont été effectués pour des procédés de restauration de l'élément photovoltaïque 10 réalisés à une température de 25 °C et à une intensité d'éclairement de 1000 W/m$^2$. La figure 5a correspond aux résultats obtenus pour un procédé utilisant un éclairement en face avant par un spectre de type AM1.5G, alors que les résultats de la figure 5b correspondent à un éclairement en face avant par un rayonnement monochromatique infrarouge dont la longueur d'onde est égale à 1000 nm.

Les figures 5a et 5b montrent l'effet positif résultant de l'utilisation d'un fort champ magnétique en combinaison avec un éclairement par un rayonnement infrarouge. En effet, cette combinaison permet d'obtenir avantageusement une distribution uniforme de la concentration moyenne des porteurs de charge $\Delta n$. En plus de l'uniformité de la distribution de la concentration moyenne, l'utilisation d'un éclairement monochromatique infrarouge permet une nette augmentation de la concentration Δn, notamment au niveau de la région émettrice 1E et de l'interface 24 du substrat 1 à traiter, autrement dit au niveau de la jonction p/n. Cette augmentation et cette uniformité permettent de manière avantageuse une guérison plus rapide et plus uniforme, selon la profondeur, de l'élément photovoltaïque 10 à traiter.

L'application d'un champ magnétique transverse dans le substrat 1 à traiter entraîne une augmentation de la concentration moyenne Δn. Avantageusement, le procédé permet une amélioration très significative de la cinétique de restauration des éléments photovoltaïques des effets de dégradation du rendement sous éclairement.

L'accélération de la cinétique de restauration se traduit par une nette diminution du temps de régénération de l'élément photovoltaïque 10. Par temps de régénération, on entend le temps de traitement de l'élément photovoltaïque 10 nécessaire pour qu'il retrouve des performances stables sous des conditions normales de fonctionnement.

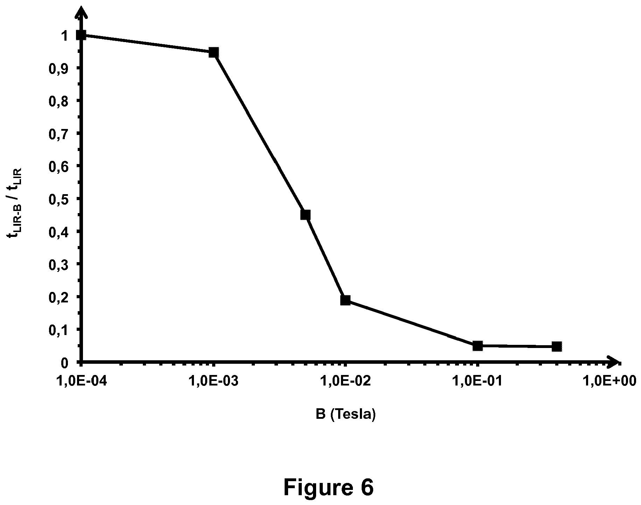

La figure 6 illustre l'évolution, en fonction de l'intensité du champ magnétique, du rapport de temps de régénération de l'élément photovoltaïque 10 en utilisant un champ magnétique $t_{LIR-B}$, sur le temps de régénération de l'élément photovoltaïque avec un procédé standard $t_{LIR}$. Par procédé standard, on entend un procédé n'utilisant pas un champ magnétique appliqué à l'élément photovoltaïque. A l'exception de l'application d'un champ magnétique, les deux procédés ont les mêmes conditions de mise en oeuvre. Les calculs ont été effectués en considérant que les procédés de restauration de l'élément photovoltaïque 10 ont été réalisés à une température de 127 °C, et en utilisant un rayonnement monochromatique infrarouge avec une irradiance de 1000 W/m².

La figure 6 montre clairement que l'utilisation d'un champ magnétique appliqué à l'élément photovoltaïque 10 pendant le procédé de restauration permet de réduire considérablement le temps de régénération, notamment pour des intensités du champ magnétique supérieures à $5 \times 10^{-3}$ T. Par exemple, en utilisant un champ magnétique dont l'intensité est égale à 0,01 T, le temps de régénération ($t_{LIR-B}$) correspond au temps de régénération par le procédé standard ($t_{LIR}$) divisé à peu près par 5 pour l'élément photovoltaïque 10 à base d'un substrat 1 présentant une durée de vie dans le volume de $10^{-3}$ s.

Le procédé de restauration utilisant un champ magnétique transverse appliqué à l'élément photovoltaïque 10, permet de réduire considérablement le temps de régénération. Ainsi, le procédé de restauration est avantageusement compatible avec les procédés industriels de fabrication des cellules solaires photovoltaïques.

Par ailleurs, en fixant le temps de régénération, le procédé de restauration utilisant un champ magnétique permet, de manière avantageuse, de réduire l'intensité d'éclairement, ou l'irradiance. A titre d'exemple, l'utilisation d'un champ magnétique appliqué à l'élément photovoltaïque 10 ayant une intensité de 0,01 T, permet de diviser à peu près par 3 l'intensité d'éclairement nécessaire pour la régénération pour le substrat présentant une durée de vie dans le volume de $10^{-3}$ s. Ainsi, il est envisageable d'utiliser des sources d'éclairement moins intenses consommant moins d'énergie.

Les différentes expériences et les différents calculs réalisés lors de l'étude du procédé de traitement utilisant un champ magnétique transverse ont permis d'établir des formules mathématiques reliant le temps nécessaire à la régénération complète $t_{LIR-B}$ en fonction des principaux paramètres du procédé. En effet, les formules mathématiques donnent le temps $t_{LIR-B}$ en fonction de la température T en Kelvin de l'élément photovoltaïque à traiter, de l'intensité du champ magnétique transverse Bc en tesla appliqué à l'élément photovoltaïque 10 à traiter, et de l'irradiance I en sun. L'irradiance correspond à l'intensité du rayonnement projeté sur la face avant 1a du substrat 1. Dans le système international d'unités, 1 sun correspond à 1000 W/m². Les formules mathématiques ont été établies pour des éléments photovoltaïques 10 à base de substrats en silicium dopés p, et pour des intensités de champ magnétique transverse Bc comprises entre $10^{-4}$ à 0,4 T.

Ainsi, selon un mode préférentiel de réalisation, l'élément photovoltaïque 10 est réalisé à partir d'un substrat en silicium dopé bore avec une concentration comprise entre $4 \times 10^{14}$ at/cm³ et $7 \times 10^{16}$ at/cm³. Selon ce mode de réalisation, le temps de traitement t en secondes est avantageusement supérieur ou égale à :

$$C_1 * \left( \left( C_2 + \frac{1 - C_2}{1 + \left( \dfrac{B_c}{0,0169} \right)^{1,7352}} \right) * I \right)^{C_3} * e^{C_4 / T} \qquad (1)$$

où t désigne le temps pendant lequel le substrat est maintenu à une température comprise entre 20 et 230 °C, tout en générant les porteurs de charge et tout en appliquant le champ magnétique B, T correspond à la température en kelvin de l'élément photovoltaïque 10, $B_c$ correspond à l'intensité en tesla de ladite composante Bc du champ magnétique B, I correspond à l'irradiance en sun du rayonnement projeté sur la face avant 1a du substrat 1. Par ailleurs, dans la formule (1), $C_1$ correspond à une première constante comprise entre $1,3 \times 10^{-5}$ et $3,2 \times 10^{-5}$ et préférentiellement égale à $1,7 \times 10^{-5}$, $C_2$ correspond à une deuxième constante comprise entre 1,00 et 32,0 et préférentiellement égale à 4,32, $C_3$ correspond

à une troisième constante comprise entre -1,00 et -2,00 et préférentiellement égale à -1,62, et $C_4$ correspond à une quatrième constante comprise entre 6562 et 8523 et préférentiellement égale à 7500.

Selon un autre mode préférentiel de réalisation, l'élément photovoltaïque 10 est réalisé à partir d'un substrat 1 en silicium dopé bore avec une concentration strictement supérieure à $7 \times 10^{16}$ at/cm³. Selon ce mode de réalisation, le temps de traitement t en secondes est supérieure ou égale à :

$$\left( \frac{C_1'}{\left( C_2' + \frac{1 - C_2'}{1 + \left( \frac{B_c}{0,0169} \right)^{1,7352}} \right) * I} + C_3' \right) * e^{C_4'/T} \qquad (2)$$

où t désigne le temps pendant lequel le substrat est maintenu à une température comprise entre 20 et 230 °C, tout en générant les porteurs de charge et tout en appliquant le champ magnétique B, T correspond à la température en kelvin de l'élément photovoltaïque 10, $B_c$ correspond à l'intensité en tesla de ladite composante Bc du champ magnétique B, I correspond à l'irradiance en sun du rayonnement projeté sur la face avant 1a de l'élément photovoltaïque 10. Par ailleurs, dans la formule (2), $C_1'$ correspond à une première constante additionnelle comprise entre $1,20 \times 10^{-8}$ et $1,90 \times 10^{-8}$ et préférentiellement égale à $1,51 \times 10^{-8}$, $C_2'$ correspond à une deuxième constante additionnelle comprise entre 1,00 et 32,0 et préférentiellement égale à 4,32, $C_3'$ correspond à une troisième constante additionnelle comprise entre $2,5 \times 10^{-8}$ et $4 \times 10^{-8}$ et préférentiellement égale à $3,7 \times 10^{-8}$, et $C_4'$ correspond à une quatrième constante additionnelle comprise entre 6562 et 8523 et préférentiellement égale à 7500.

Par ailleurs, on prévoit également un dispositif destiné à réaliser le procédé de traitement décrit selon les différents modes de réalisation présentés ci-dessus.

Selon un mode de réalisation illustré à la figure 1, le dispositif de restauration 20 est configuré pour guérir l'élément photovoltaïque 10. Ce dernier comporte le substrat 1 muni de la face avant 1a et de la face arrière 1b opposées et de préférence sensiblement parallèles. La face avant 1a est destinée à recevoir une intensité lumineuse, ou une irradiance. Le substrat 1 comporte la région émettrice 1E au niveau de la face 1a, et la région de base 1B. Le dispositif 20 comporte des moyens de génération 2 de porteurs de charge dans le substrat 1.

Les moyens de génération 2 de porteurs de charge comportent préférentiellement la source lumineuse 2 éclairant l'élément photovoltaïque 10 à traiter. La source lumineuse 2 peut comporter des lampes monochromatiques ou multispéctrales permettant de produire un faisceau lumineux incident ayant une longueur d'onde préférentiellement comprise entre 300 et 1300 nm.

La source lumineuse 2 peut aussi bien comporter des lampes halogènes ou xénon. Selon un exemple de réalisation la source lumineuse est formée par des lampes en xénon permettant d'avoir un éclairement continu de l'élément photovoltaïque 10 à traiter avec une irradiance d'environ 1000 W/m². Avantageusement, la source lumineuse 2 est configurée pour fournir un éclairement intense de manière à ce que les éléments photovoltaïques 10 reçoivent un éclairement supérieur à $5 \times 10^4$ W/m².

Par ailleurs, la source lumineuse 2 peut comporter des LED ou encore une source laser, qui génère avantageusement un éclairement intense. L'utilisation d'une source laser ou des LED permet avantageusement une réduction de la consommation énergétique, en comparaison avec les autres sources lumineuses.

Le dispositif de traitement 20 comporte également des moyens de traitement thermique 3 configurés pour maintenir le substrat 1 à une température comprise dans l'intervalle de température 20 °C - 230 °C, et de préférence dans l'intervalle de température 50 °C - 230 °C. Les moyens de traitement thermique 3 peuvent comporter une source de chaleur. Par ailleurs, les moyens de génération 2 de porteurs de charge peuvent également former les moyens de traitement thermique 3. Par exemple des lampes halogènes peuvent éclairer la cellule solaire 1 tout en la réchauffant.

Comme illustré à la figure 1, le contrôle de la température du substrat 1 est préférentiellement réalisé par une enceinte 3 configurée pour maintenir la température du substrat 1 à une valeur ou une plage de température cible. L'enceinte 3 peut être un four classique muni de capteurs de température configurés pour mesurer la température du substrat 1. Le four peut également comporter un dispositif de régulation de la température de l'élément photovoltaïque 10. Le dispositif de régulation est connecté à un circuit de commande configuré pour contrôler la température du four et le dispositif de régulation en fonction de la température de l'élément photovoltaïque 10.

Par ailleurs, les moyens de contrôle 3 de la température du substrat 1 sont configurés pour que l'élément photovoltaïque 10 soit éclairé. Par exemple, l'enceinte 3 de maintien de la température de l'élément photovoltaïque 10 peut comporter la source lumineuse 2.

Préférentiellement, l'enceinte 3 comporte une paroi transparente au rayonnement émis par la source d'éclairement 2. La paroi transparente est interposée entre la source d'éclairement 3 et la face avant 1a de l'élément photovoltaïque 10, de sorte à laisser passer le rayonnement émis par la source 2, éclairant ainsi la face avant 1a du substrat 1.

En outre, le dispositif comporte des moyens d'application 4 d'un champ magnétique B configurés pour que le champ magnétique B ait une composante Bc sensiblement parallèle à l'interface 24 entre la région émettrice 1E et le substrat 1. Préférentiellement, la composante Bc est perpendiculaire à un axe (Ox) traversant la face avant 1a et la face arrière 1b.

Selon un exemple de réalisation, les moyens d'application 4 comportent deux aimants permanents 11 et 12 séparés par un entrefer 13. Les aimants 11 et 12 sont montés sur un support 14 de sorte qu'ils soient disposés en regard. L'aimant 11 comporte une face 11' disposée en regard d'une face 12' de l'aimant 12. Les aimants 11 et 12 sont configurés de sorte que les faces 11' et 12' disposées en regard aient des pôles magnétiques opposés (N et S).

Les aimants 11 et 12 sont configurés pour créer le champ magnétique transverse B balayant l'espace de l'entrefer 13. En fonction de l'architecture et de la composition de l'élément photovoltaïque 10 ou le substrat 1, et de l'enceinte 3, les aimants 11 et 12 sont disposés de sorte à créer le champ magnétique B ayant une composante Bc sensiblement parallèle à l'interface 24. Préférentiellement, l'interface 24 est parallèle aux faces 1a et 1b, et les aimants 11 et 12 sont configurés et disposés de sorte que le champ magnétique B créé ait une direction parallèle aux faces 1a et 1b.

Par ailleurs, l'entrefer 13 est configuré pour comporter l'élément photovoltaïque 10 à traiter. Autrement dit, l'entrefer 13 est configuré pour abriter l'enceinte 3 comportant l'élément photovoltaïque 10. De manière préférentielle, le dispositif 20 comporte des moyens de fixation (non représentés à la figure) des éléments situés dans l'entrefer 13, notamment des moyens de fixation de l'élément photovoltaïque 10. La fixation des éléments disposés dans l'entrefer 13 permet d'éviter la distorsion des lignes de champ magnétique créées dans le substrat 1. Ce qui permet d'avoir un procédé de traitement stable et homogène dans le substrat 1.

Préférentiellement, l'enceinte 3 est à base de matériaux ayant des perméabilités magnétiques relatives proches de 1. Par exemple, l'enceinte 3 peut être à base d'aluminium. En effet, un matériau ayant une perméabilité magnétique proche de 1, permet de manière avantageuse, d'atténuer la distorsion des lignes de champ magnétique au sein du substrat 1. Ainsi, les aimants 11 et 12 créent un flux homogène du champ magnétique B dans le substrat 1 disposé dans l'entrefer 13.

Selon un exemple de réalisation, les deux aimants 11 et 12 sont de type Nb ayant une densité de flux résiduel de 1320 mT, et un champ magnétique coercitif supérieur à 11 Oesterd. Les aimants 11 et 12 sont des barreaux cylindriques ayant une section circulaire d'un un rayon de 100 mm. Les barreaux cylindriques 11 et 12 ont une épaisseur de 30 mm. Par épaisseur, on entend la dimension des aimants 11 et 12 selon l'axe (Oy). Les aimants 11 et 12 sont séparés d'une distance d'environ 150 mm. Autrement dit, la dimension de l'entrefer 13 selon l'axe (Oy) est d'environ 150 mm. Ainsi, l'entrefer 13 peut abriter un élément photovoltaïque commercial disposée de sorte que les faces 1a et 1b soient parallèles à l'axe (Oy).

En utilisant des formules mathématiques connues de l'état de la technique, la densité de flux, autrement dit l'intensité du champ magnétique B le long de l'axe (Oy) de l'entrefer 13 peut être calculée à partir des caractéristiques et des dimensions des aimants 11 et 12.

Ainsi, selon l'exemple de réalisation décrit ci-dessus, les aimants 11 e 12 permettent de créer dans l'entrefer 13, un champ magnétique transverse B ayant une direction parallèle à l'axe (Oy) et une intensité comprise entre 250 mT et 400 mT.

Selon un mode de réalisation non illustré aux figures, les moyens d'application 4 du champ magnétique B comportent un électroaimant. En effet, le champ magnétique B peut être généré par les aimants permanents 11 et 12 et/ou par un électroaimant comportant par exemple une bobine électromagnétique. La distribution finale des lignes de champ magnétique dépend de la configuration finale de l'installation des aimants 11 et 12 et/ou de l'électroaimant. Cette distribution peut être non uniforme engendrant ainsi une irrégularité de l'intensité du champ magnétique B dans le substrat 1 à traiter.

Dans tous les cas, l'installation doit être dimensionnée, et les moyens d'application 4 doivent être arrangés de manière à garantir une valeur minimale de l'intensité du champ magnétique appliqué à un élément photovoltaïque 10 à traiter, et une composante Bc sensiblement parallèle à l'interface 24, et préférentiellement perpendiculaire à l'axe (Ox) traversant la face avant 1a et la face arrière 1b.

Selon un autre mode de réalisation, les moyens de génération 2 de porteurs de charge dans le substrat 1 comportent des moyens d'injection d'un courant électrique dans le substrat 1. Les moyens d'injection du courant sont externes à l'élément photovoltaïque 10.

Les moyens d'injection d'un courant électrique dans le substrat 1 peuvent former un complément à une source de lumière éclairant l'élément photovoltaïque 10. Par ailleurs, les moyens d'injection d'un courant peuvent également remplacer la source de lumière configurée pour générer des porteurs de charges minoritaires au sein de l'élément photovoltaïque 10 à traiter.

Les moyens d'injection peuvent comporter des pointes, reliées à un générateur de différence de potentiel. Lesdites pointes sont configurées pour être en contact avec les contacts 23 de l'élément photovoltaïque 10 pour y injecter un courant électrique.

Le générateur de différence de potentiel est configuré pour imposer aux bornes de l'élément photovoltaïque 10 une différence de potentiel supérieure à la tension de l'élément photovoltaïque en circuit ouvert. Préférentiellement, le générateur de différence de potentiel est configuré pour imposer à l'élément photovoltaïque 10, une différence de potentielle typiquement supérieur à 0,6 ou 0,75 V. Par ailleurs, le courant à injecter dans l'élément photovoltaïque 10 dépend des caractéristiques de ce dernier et de la concentration de porteurs qu'on cherche à injecter.

Selon un autre mode de réalisation, le dispositif de traitement 20 est configuré pour traiter plusieurs éléments photovoltaïques simultanément. L'enceinte 3 est ainsi configurée pour accueillir plusieurs éléments photovoltaïques disposés dans l'entrefer 13.

Avantageusement, les éléments photovoltaïques sont disposés parallèlement à l'axe (Oy) de manière à être l'un au dessus de l'autre de sorte que l'axe (Ox) traverse tous les éléments photovoltaïques empilés. Selon ce mode de réalisation, les moyens d'injection 2 de porteurs de charge sont avantageusement constitués par des moyens d'injection d'un courant électrique. De manière préférentielle, les éléments photovoltaïques à traiter sont électriquement connectés en série.

**Revendications**

1. Procédé de traitement d'un élément photovoltaïque (10) contre la dégradation du rendement sous éclairement, comportant au moins les étapes suivantes :

   - prévoir ledit élément (10) comportant un substrat (1) à base de silicium, muni en surface d'au moins une région émettrice (1E);
   - générer des porteurs de charge dans le substrat (1), tout en maintenant le substrat (1) à une température comprise dans un intervalle de température compris entre 20°C et 230 °C et de préférence entre 50°C et 230°C;

   **caractérisé en ce que** le substrat (1) est soumis à un champ magnétique (B) pendant l'étape de génération des porteurs de charge, le champ magnétique (B) ayant une composante (Bc) sensiblement parallèle à l'interface (24) entre la région émettrice (1E) et le substrat (1),
   et **en ce que** la composante (Bc) du champ magnétique (B) a une intensité comprise entre $10^{-4}$ T et $5.10^{-1}$ T et avantageusement supérieure à $10^{-3}$ T.

2. Procédé selon la revendication 1, **caractérisé en ce que** l'étape de génération des porteurs de charge est obtenue par éclairement du substrat (1).

3. Procédé selon la revendication 2, **caractérisé en ce que** l'éclairement est obtenu en utilisant une lumière ayant une longueur d'onde supérieure ou égale à 500nm, et de préférence supérieure ou égale 800nm, et inférieure ou égale à 1300nm, et de préférence inférieure ou égale à 1000nm.

4. Procédé de traitement selon la revendication 1, **caractérisé en ce que** :

   - le substrat (1) est en silicium dopé bore avec une concentration comprise entre $4,0 \times 10^{14}$ at/cm$^{-3}$ et $7,0 \times 10^{16}$ at/cm$^{-3}$, et
   - le temps de traitement (t) de l'élément photovoltaïque (10), en secondes, est supérieure ou égale à :

$$C_1 * \left( \left( C_2 + \frac{1 - C_2}{1 + \left( \dfrac{B_c}{0,0169} \right)^{1,7352}} \right) * I \right)^{C_3} * e^{C_4 / T}$$

où :

- T correspond à la température en kelvin du substrat (1) ;
- $B_c$ correspond à l'intensité en Tesla de ladite composante (Bc) du champ magnétique (B) ;
- I correspond à l'irradiance en sun du rayonnement projeté sur la surface (1a) du substrat (1) ;
- $C_1$ correspond à une première constante comprise entre $1,3 \times 10^{-5}$ et $3,2 \times 10^{-5}$ et préférentiellement égale à $1,7 \times 10^{-5}$ ;
- $C_2$ correspond à une deuxième constante comprise entre 1,00 et 32,0 et préférentiellement égale à 4,32 ;
- $C_3$ correspond à une troisième constante comprise entre -1,00 et -2,00 et préférentiellement égale à -1,62 ;
- $C_4$ correspond à une quatrième constante comprise entre 6562 et 8523 et préférentiellement égale à 7500.

5. Procédé de traitement selon la revendication 1, **caractérisé en ce que** :

- le substrat (1) est en silicium dopé bore avec une concentration strictement supérieure à $7 \times 10^{16}$ at/cm$^{-3}$ ; et
- le temps de traitement (t) de l'élément photovoltaïque (10), en secondes, est supérieure ou égale à :

$$\left( \frac{C_1'}{\left( C_2' + \dfrac{1 - C_2'}{1 + \left( \dfrac{B_c}{0,0169} \right)^{1,7352}} \right) * I} + C_3' \right) \ * \ e^{C_4' / T}$$

où :

- T correspond à la température en kelvin du substrat (1) ;
- $B_c$ correspond à l'intensité en tesla de ladite composante (Bc) du champ magnétique (B) ;
- I correspond à l'irradiance en sun du rayonnement projeté sur la surface (1a) du substrat (1) ;
- $C'_1$ correspond à une première constante additionnelle comprise entre $1,2 \times 10^{-8}$ et $1,9 \times 10^{-8}$ et préférentiellement égale à $1,51 \times 10^{-8}$ ;
- $C'_2$ correspond à une deuxième constante additionnelle comprise entre 1,00 to 32,0 et préférentiellement égale à 4,32 ;
- $C'_3$ correspond à une troisième constante additionnelle comprise entre $2,5 \times 10^{-8}$ et $4,0 \times 10^{-8}$ et préférentiellement égale à $4,0 \times 10^{-8}$ ; et
- $C'_4$ correspond à une quatrième constante additionnelle comprise entre 6562 et 8523 et préférentiellement égale à 7500.

6. Procédé selon l'une quelconque des revendications 1 à 5, **caractérisé en ce qu'**il comporte une étape de formation de contacts électriques (23) sur le substrat (1) et **en ce que** l'étape de génération des porteurs de charge comporte une application d'une tension électrique externe aux contacts électriques (23).

7. Dispositif de traitement d'un élément photovoltaïque (10) contre la dégradation du rendement sous éclairement, l'élément photovoltaïque (10) comprenant un substrat (1) en silicium muni d'au moins une région émettrice (1E) comportant :

- des moyens de génération (2) de porteurs de charge dans le substrat (1),
- des moyens de traitement thermique (3) configurés pour maintenir le substrat (1) à une température comprise dans l'intervalle de température entre 20 °C et 230 °C et de préférence entre 50°C et 230°C ; et
- des moyens d'application (4) d'un champ magnétique (B) balayant un entrefer (13) configuré pour comporter l'élément photovoltaïque (10), lesdits moyens d'application (4) étant configurés pour que le champ magnétique (B) ait une composante (Bc) sensiblement parallèle à l'interface (24) entre la région émettrice (1E) et le substrat (1), et pour que la composante (Bc) du champ magnétique (B) a une intensité comprise entre $10^{-4}$ T et $5.10^{-1}$ T et avantageusement supérieure à $10^{-3}$ T.

**8.** Dispositif selon la revendication 7, **caractérisé en ce que** les moyens d'application (4) d'un champ magnétique (B) comportent des aimants permanents (11', 12').

**9.** Dispositif selon l'une des revendications 7 et 8, **caractérisé en ce que** les moyens d'application (4) d'un champ magnétique (B) comportent un électroaimant.

**10.** Dispositif selon la revendication 7, **caractérisé en ce que** les moyens de génération (2) de porteurs de charge dans l'élément photovoltaïque (10) comportent une source lumineuse destinée à éclairer l'élément photovoltaïque (10).

**11.** Dispositif selon la revendication 7, **caractérisé en ce que** le substrat (1) est muni de contacts électriques (23) et **en ce que** les moyens de génération (2) de porteurs de charge dans le substrat (1) comportent des moyens d'application d'une tension électrique externe aux contacts électriques (23).

## Patentansprüche

**1.** Verfahren zur Behandlung eines Photovoltaik-Elements (10) gegen die Wirkungsgradverschlechterung unter Einstrahlung, das folgende Verfahrensschritte umfasst:

- Vorlegen des genannten Elements (10), das ein Substrat (1) auf Silizium-Basis enthält, das an der Oberfläche mit mindestens einer Emissionszone (1E) versehen ist;
- Erzeugen von Ladungsträgern in dem Substrat (1) auf Silizium-Basis, wobei das Substrat (1) auf einer Temperatur gehalten wird, die innerhalb eines Temperaturbereichs von 20°C bis 230°C, und vorzugsweise von 50°C bis 230°C liegt;

**dadurch gekennzeichnet,**
**dass** das Substrat (1) während des Verfahrensschritts des Erzeugens von Ladungsträgern einem Magnetfeld (B) ausgesetzt wird, wobei das Magnetfeld (B) eine Komponente (Bc) aufweist, die im Wesentlichen parallel zu der Grenzfläche (24) zwischen der Emissionszone (1E) und dem Substrat (1) ist, und dadurch, dass die Komponente (Bc) des Magnetfelds (B) eine Stärke von $10^{-4}$ T bis $5.10^{-1}$ T und vorteilhafterweise von mehr als $10^{-3}$ T hat.

**2.** Verfahren nach Anspruch 1,
**dadurch gekennzeichnet,**
**dass** der Verfahrensschritt des Erzeugens von Ladungsträgern durch Lichtbestrahlung des Substrats (1) erfolgt.

**3.** Verfahren nach Anspruch 2,
**dadurch gekennzeichnet,**
**dass** die Lichtbestrahlung unter Verwendung eines Lichts mit einer Wellenlänge von größer oder gleich 500nm und vorzugsweise von größer oder gleich 800nm sowie kleiner oder gleich 1300nm und vorzugsweise kleiner oder gleich 1000nm erfolgt.

**4.** Behandlungsverfahren nach Anspruch 1,
**dadurch gekennzeichnet,**
**dass**

- das Substrat (1) aus Bor-dotiertem Silizium mit einer Konzentration von $4,0x10^{14}$ at/cm$^{-3}$ bis $7,0x10^{16}$ at/cm$^{-3}$ besteht, und
- die Behandlungsdauer (t) des Photovoltaik-Elements (10) in Sekunden größer oder gleich :

$$C_1 * \left( \left( C_2 + \cfrac{1-C_2}{1+\left(\cfrac{B_c}{0,0169}\right)^{0,882}} \right) * I \right)^{C_3} * e^{C_4/T}$$

ist, wobei:

- T für die Temperatur des Substrats (1) in Kelvin steht;
- $B_c$ für die Stärke der genannten Komponente (Bc) des Magnetfeldes (B) steht;
- I für die Strahlungsstärke in SUN der auf die Oberfläche (1a) des Substrats (1) gerichteten Bestrahlung steht;
- $C_1$ für eine erste Konstante steht, die zwischen $1,3 \times 10^{-5}$ und $3,2 \times 10^{-5}$ beträgt und vorzugsweise gleich $1,7 \times 10^{-5}$ ist;
- $C_2$ für eine zweite Konstante steht, die zwischen 1,00 und 32,0 beträgt und vorzugsweise gleich 4,32 ist;
- $C_3$ für eine dritte Konstante steht, die zwischen -1,00 und -2,00 beträgt und vorzugsweise gleich -1,62 ist;
- $C_4$ für eine vierte Konstante steht, die zwischen 6562 und 8523 beträgt und vorzugsweise gleich 7500 ist.

5.  Behandlungsverfahren nach Anspruch 1,
    **dadurch gekennzeichnet,**
    **dass**

    - das Substrat (1) aus Bor-dotiertem Silizium mit einer Konzentration, die unbedingt höher ist als $7 \times 10^{16}$ at/cm$^{-3}$, besteht, und
    - die Behandlungsdauer (t) des Photovoltaik-Elements (10) in Sekunden größer oder gleich :

$$\left( \cfrac{C'_1}{\left( C'_2 + \cfrac{1-C'_2}{1+\left(\cfrac{B_c}{0,0169}\right)^{0,882}} \right) * I} + C'_3 \right) * e^{C'_4/T}$$

ist, wobei

- T für die Temperatur des Substrats (1) in Kelvin steht;
- $B_c$ für die Stärke der genannten Komponente (Bc) des Magnetfeldes (B) steht;
- I für die Strahlungsstärke in SUN der auf die Oberfläche (1a) des Substrats (1) gerichteten Bestrahlung steht;
- $C'_1$ für eine erste zusätzliche Konstante steht, die zwischen $1,2 \times 10^{-8}$ und $1,9 \times 10^{-8}$ beträgt und vorzugsweise gleich $1,51 \times 10^{-8}$ ist;
- $C'_2$ für eine zweite zusätzliche Konstante steht, die zwischen 1,00 und 32,0 beträgt und vorzugsweise gleich 4,32 ist;
- $C'_3$ für eine dritte zusätzliche Konstante steht, die zwischen $2,5 \times 10^{-8}$ und $4,0 \times 10^{-8}$ beträgt und vorzugsweise gleich $4,0 \times 10^{-8}$ ist;
- $C'_4$ für eine vierte zusätzliche Konstante steht, die zwischen 6562 und 8523 beträgt und vorzugsweise gleich 7500 ist.

6.  Verfahren nach einem der Ansprüche 1 bis 5,
    **dadurch gekennzeichnet,**
    **dass** es einen Verfahrensschritt der Bildung von elektrischen Kontakten (23) auf dem Substrat (1) enthält und dass der Verfahrensschritt des Erzeugens von Ladungsträgern ein Anlegen einer externen elektrischen Spannung an die elektrischen Kontakte (23) umfasst.

7. Vorrichtung zur Behandlung eines Photovoltaik-Elements (10) gegen die Wirkungsgradverschlechterung unter Einstrahlung, wobei das Photovoltaik-Element (10) ein Substrat (1) aus Silizium enthält, das mit mindestens einer Emissionszone (1E) versehen ist, wobei die Vorrichtung umfasst:

- Mittel zur Erzeugung (2) von Ladungsträgern in dem Substrat (1),
- Mittel zur Wärmebehandlung (3), die dazu ausgeführt sind, das Substrat (1) auf einer Temperatur zu halten, die in dem Temperaturbereich von 20°C bis 230°C und vorzugsweise von 50°C bis 230°C liegt; und
- Mittel zum Anwenden (4) eines Magnetfelds (B), das auf einen Spalt (13) einwirkt, der dazu ausgeführt ist, das Photovoltaik-Element (10) aufzunehmen, wobei diese Anwendemittel (4) so ausgeführt sind, dass das Magnetfeld (B) eine Komponente (Bc) aufweist, die im Wesentlichen parallel zu der Grenzfläche (24) zwischen der Emissionszone (1E) und dem Substrat (1) ist, und dass die Komponente (Bc) des Magnetfelds (B) eine Stärke von $10^{-4}$ T bis $5.10^{-1}$ T und vorteilhafterweise von mehr als $10^{-3}$ T hat.

8. Vorrichtung nach Anspruch 7,
**dadurch gekennzeichnet,**
**dass** die Mittel zum Anwenden (4) eines Magnetfelds (B) Dauermagneten (11', 12') umfassen.

9. Vorrichtung nach einem der Ansprüche 7 und 8,
**dadurch gekennzeichnet,**
**dass** die Mittel zum Anwenden (4) eines Magnetfelds (B) einen Elektromagneten umfassen.

10. Vorrichtung nach Anspruch 7,
**dadurch gekennzeichnet,**
**dass** die Mittel zur Erzeugung (2) von Ladungsträgern in dem Photovoltaik-Element (10) eine Lichtquelle enthalten, die dazu bestimmt ist, das Photovoltaik-Element (10) zu bestrahlen.

11. Vorrichtung nach Anspruch 7,
**dadurch gekennzeichnet,**
**dass** das Substrat (1) mit elektrischen Kontakten (23) versehen ist und dass die Mittel zur Erzeugung (2) von Ladungsträgern in dem Substrat (1) Mittel zum Anlegen einer externen elektrischen Spannung an die elektrischen Kontakte (23) enthalten.

**Claims**

1. A treatment method of a photovoltaic element (10) against degradation of the efficiency under illumination treatment, comprising at least the following steps:

- providing said element (10) comprising a silicon-base substrate (1) provided with at least one emitter area (1E) at the surface;
- generating charge carriers in the substrate (1), while at the same time keeping the substrate (1) at a temperature within a temperature range comprised between 20 °C and 230 °C and preferably between 50 °C and 230 °C;

**characterized in that** the substrate (1) is subjected to a magnetic field (B) during the charge carrier generation step, the magnetic field (B) having a component (Bc) substantially parallel to the interface (24) between the emitting area (1E) and the substrate (1),
and **in that** the component (Bc) of the magnetic field (B) has an intensity comprised between $10^{-4}$ T and $5*10^{-1}$ T and advantageously greater than $10^{-3}$ T.

2. The treatment method according to claim 1, **characterized in that** the charge carrier generation step is obtained by illumination of the substrate (1).

3. The treatment method according to claim 2, **characterized in that** the illumination is obtained using a light having a wavelength greater than or equal to 500nm, and preferably greater than or equal to 800nm, and lower than or equal to 1300nm, and preferably lower than or equal to 1000nm.

4. The treatment method according to claim 1, **characterized in that**:

- the substrate (1) is made from boron-doped silicon with a concentration comprised between $4.0 \times 10^{14}$ at/cm$^{-3}$ and $7.0 \times 10^{16}$ at/cm$^{-3}$; and
- the restoration time (t) of the photovoltaic element (10) in seconds is greater than or equal to:

$$C_1 * \left( \left( C_2 + \frac{1 - C_2}{1 + \left( \dfrac{B_c}{0.0169} \right)^{1.7352}} \right) * I \right)^{C_3} * e^{C_4 / T}$$

where:

- T corresponds to the temperature in kelvin of the substrate (1);
- $B_c$ corresponds to the intensity in Tesla of said component (Bc) of the magnetic field (B);
- I corresponds to the irradiance in sun of the radiation projected onto the surface (1a) of the substrate (1);
- $C_1$ corresponds to a first constant comprised between $1.3 \times 10^{-5}$ and $3.2 \times 10^{-5}$ and preferably equal to $1.7 \times 10^{-5}$;
- $C_2$ corresponds to a second constant comprised between 1.00 and 32.0 and preferably equal to 4.32;
- $C_3$ corresponds to a third constant comprised between -1.00 and -2.00 and preferably equal to -1.62;
- $C_4$ corresponds to a fourth constant comprised between 6562 and 8523 and preferably equal to 7500.

5. The treatment method according to claim 1, **characterized in that**:

- the substrate (1) is made from boron-doped silicon with a concentration strictly greater than $7 \times 10^{16}$ at/cm$^{-3}$; and
- the restoration time (t) of the photovoltaic treatment (10) in seconds is greater than or equal to:

$$\left( \frac{C_1'}{\left( C_2' + \dfrac{1 - C_2'}{1 + \left( \dfrac{B_c}{0.0169} \right)^{1.7352}} \right) * I} + C_3' \right) * e^{C_4' / T}$$

where:

- T corresponds to the temperature in kelvin of the substrate;
- $B_c$ corresponds to the intensity in Tesla of said component (Bc) of the magnetic field (B);
- I corresponds to the irradiance in sun of the radiation projected onto the surface (1a) of the substrate (1);
- $C'_1$ corresponds to an additional first constant comprised between $1.2 \times 10^{-8}$ and $1.9 \times 10^{-8}$ and preferably equal to $1.51 \times 10^{-8}$;
- $C'_2$ corresponds to an additional second constant comprised between 1.00 to 32.0 and preferably equal to 4.32;
- $C'_3$ corresponds to an additional third constant comprised between $2.5 \times 10^{-8}$ and $4.0 \times 10^{-8}$ and preferably equal to $4.0 \times 10^{-8}$; and
- $C'_4$ corresponds to an additional fourth constant comprised between 6562 and 8523 and preferably equal to 7500.

6. The treatment method according to any one of claims 1 to 5, **characterized in that** it comprises a formation step of electric contacts (23) on the substrate (1) and **in that** the charge carrier generation step comprises application of an external electric voltage to the electric contacts (23).

7. A treatment device of a photovoltaic element (10) against degradation of the efficiency under illumination, the photovoltaic element (10) comprising a silicon substrate (1) provided with at least one emitter area (1E), comprising:

- means (2) for generating charge carriers in the substrate (1);
- thermal treatment means (3) configured to keep the substrate (1) at a temperature comprised within the temperature range between 20 °C and 230 °C and preferably between 50°C and 230°C; and
- means (4) for applying a magnetic field (B) flowing through an air-gap (13) configured to comprise the photovoltaic element (10), said means (4) for applying being configured so that the magnetic field (B) has a component (Bc) substantially parallel to the interface (24) between the emitter area (1E) and the substrate (1), and so that the component (Bc) of the magnetic field (B) has an intensity comprised between $10^{-4}$ T and $5*10^{-1}$ T and advantageously greater than $10^{-3}$ T.

8. The device according to claim 7, **characterized in that** the application means (4) of a magnetic field (B) comprise permanent magnets (11', 12').

9. The device according to one claims 7 and 8, **characterized in that** the application means (4) of a magnetic field (B) comprise an electromagnet.

10. The device according to claim 7, **characterized in that** the means (2) for generating charge carriers in the photovoltaic element (10) comprise a light source designed to illuminate the photovoltaic element (10).

11. The device according to claim 7, **characterized in that** the substrate (1) is provided with electric contacts (23) and **in that** the means (2) for generating charge carriers in the substrate (1) comprise means for applying an external electric voltage to the electric contacts (23).

EP 3 021 365 B1

Figure 1

Figure 2

17

**Figure 3**

**Figure 4**

Figure 5a

Figure 5b

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007107351 A